# EUROPEAN PATENT APPLICATION

(11) **EP 1 024 523 A1**
(43) Date of publication of application: **02.08.2000**
(21) Application number: 99200235.2
(22) Date of filing: 27.01.1999
(51) Int. Cl.: H01L 21/20, H01L 31/18

(54) **Method for fabricating thin film semiconductor devices**

(71) Applicant: Imec (Interuniversity Microelectronics Center) VZW, 3001 Leuven (BE)
(72) Inventor: Horzel, Jörg, 3001 Leuven (BE); Vazsonyi, Eva, 1026 Budapest (HU)
(74) Representative: Bird, William Edward

(57) **Abstract**

The present invention is related to a method for fabricating thin film semiconductor devices on a reusable substrate. Examples of such devices are for instance solar cells, light emitting diodes and power devices. The invented method allows for simple and cheap processing techniques like for instance screen printing and electroless etching to be successfully applied in combination with thin film semiconductor devices of only a few µm thickness using very cheap supports such as plastic films. The whole process is executed on a high quality substrate which is compatible with all high temperature treatments such as e.g. diffusion and thermal oxidation. Semiconductor thin films are grown on a porous layer formed on the surface of the reusable substrate. After being attached to a cheap second substrate, i.e. the support, the completed thin film semiconductor devices are lifted off from this comparably expensive substrate at the end of the process by a wet etching of the porous layer.

## Description

### FIELD OF THE INVENTION

The present invention is related to semiconductor processing techniques for fabricating thin film semiconductor devices. Examples of such thin film semiconductor devices are for instance power devices and opto-electronic devices like e.g. solar cells.

### BACKGROUND OF THE INVENTION

Today's solar cell production is dominated by silicon based solar cells. So far, most of the produced solar cells use relatively thick crystalline Si substrates of typically 200 µm thickness or more. On the other hand, amorphous Si solar cells suffer from modest conversion efficiencies and unavoidable degradation effects. Irrespective of the solar cell concept used, nowadays the cost of the produced solar energy is for all state-of-the-art devices too high to compete with conventional energy sources. Particularly, for solar cells using thick crystalline Si substrates, having clearly the largest market share, the cost per Watt of produced energy is mainly dominated by the high substrate cost for mono- or multi-crystalline substrates. This substrate price cannot be influenced too much since good quality Si material is required to obtain desirable solar cell conversion efficiencies. Additionally this substrate price depends on developments in the micro-electronics industry since waste material from this industry is used to produce substrates for solar cells. By using adequate deposition techniques, like for instance a chemical or physical vapor deposition technique, very thin solar cells can be formed. The ability to make high-quality thin solar cells can lead to in a clear cost reduction and make prices and availability of substrates more independent from other industries.

Provided that one succeeds to diminish the substrate cost substantially and that the processing costs can further be limited by introducing as much as possible simple and cheap processing techniques, cost projections assuming a reasonable solar cell conversion efficiency of better than 10 % show that solar energy would become competitive with conventional energy sources which could lead to a breakthrough for this environmentally benign energy source. Furthermore, the use of thin film solar cells of a few µm thickness in conjunction with a plastic or polymeric support film, makes these cells very flexible and offers therefore a wider range of applications than thick crystalline Si substrates.

EP 0797258 is related to a method of making a thin film solar cell. The thin film is formed on a multi-layer porous structure having at least two layers of different porosity. This porous structure is formed on a semiconductor substrate by anodization. However anodization is known as an effective but complex technique which amongst others has a negative impact on the overall throughput of the fabrication process. As a consequence, such a technique is less suited for mass production. According to EP 0797258, the thin film can be mechanically separated from the substrate along a line of weakness defined in the porous structure. A drawback of this separation technique is that it is not suited for mass production, particularly when using techniques such as screen printing on the surface, because this inherent built-in mechanical instability will lead to yield problems. Due to this mechanical instability the thin film can be unintentionally detached from the substrate prior to the intended separation. On the other hand, if the mechanical force, required to separate the thin film from the substrate is high, i.e. the attachment is mechanically more stable, then this might cause stress and damage in the thin film layer during the separation process which leads to a deterioration of the device performance.

### OBJECTS OF THE INVENTION

It is an object of the invention to fabricate thin film semiconductor devices on a substrate which can be recycled after detaching it from the thin film semiconductor device in order to diminish the substrate cost substantially.

Another object of the invention is to introduce as much as possible simple, cheap and particularly highly reliable processing techniques during the fabrication of these thin film semiconductor device. Furthermore, the use of thin film solar cells of a few µm thickness in conjunction with a plastic or polymeric support film, makes these cells very flexible and offers therefore a wider range of applications than thick crystalline Si substrates.

It is a further object of the invention to introduce a highly reliable method to separate the thin film semiconductor devices from the reusable substrate. Preferably these thin film semiconductor devices are already fully processed, i.e. fully contacted and attached to a support, before detachment from the substrate.

### SUMMARY OF THE INVENTION

The invention deals with a method for the fabrication of thin film semiconductor devices at low cost. Examples of such devices are for instance solar cells, light emitting diodes and power devices. Also the use of semitransparent thin film solar cells for shading purposes seems to be feasible with the invented technique. Particularly, a method is disclosed for fabricating thin film semiconductor devices on a reusable substrate of a semiconductor material comprising the steps of:
providing a substrate of a semiconductor material having at least one surface;
forming at least one porous layer on said surface of said substrate;
depositing at least one semiconductor layer on said porous layer;
forming active devices in said semiconductor layer;
forming electrical contacts to said active devices;
attaching a support to the surface overlying said metal connections; and
non-mechanically detaching said substrate from said semiconductor layer by removing said porous layer with a wet chemical etch using said support as an etch mask.

The invented method allows for simple and cheap processing techniques as screen printing to be successfully applied in combination with thin solar cells of only a few µm thickness using very cheap supports such as plastic films. The whole process is executed on a high quality substrate that is well compatible with all high temperature treatments as diffusion and thermal oxidation. The thin film semiconductor devices are lifted off from this comparably expensive substrate at the end of the process after being attached to a cheap second substrate, i.e. the support. The expensive high quality substrate is recycled and can be used for many processing cycles. Therefore the substrate is not contributing very much to the general processing cost. For simplicity and clarity, in the following description and examples the thin film semiconductor devices will be limited mainly to Si solar cells, but the invention is in no way limited to thin film solar cells.

According to the method of the present invention, optionally first a structuring or texturing of the substrate can be performed. This texturing might be kept for several processing cycles and will be found back as negative profile on the thin film solar cell. After cleaning the substrate, at least one porous semiconductor layer can be formed on a surface of the substrate. Particularly, a single porous semiconductor layer can be formed having a uniform porosity or a gradient in porosity. Preferably this porous semiconductor layer is formed in one processing step by an electroless etching technique in an aqueous chemical solution. For instance a solution of H₂O, HF and HNO₃ can be used. Also other solutions known in the art can be used. Optionally this porous layer can be oxidized to form a kind of amorphous or porous SiO₂ layer. The intention is to remove these porous Si or SiO₂ layers at the end of the process in order to detach the thin film Si solar cells from the substrate. This can for instance be achieved by under-etching the thin films by solutions that etch the porous film at rather high etch rates selectively away. The detachment is however only executed at the end of the processing sequence to benefit from firm attachment to the substrate during processing. As a consequence, the thin film contains a plurality of semiconductor devices which are basically completed, fully contacted and attached to a support. Afterwards, primarily only a separation step in order to detach the thin film from the substrate and a dicing step to separate the thin film devices one from another is required. This separation step is quite a challenge because dependent on the size of the substrate, e.g. a 150mm diameter silicon wafer, one requires a process which allows to perform a lateral etch over several centimeters to remove the comparably thin porous layer, i.e. typically between 0.5 and 5 µm, in order to separate the thin film from the substrate. Moreover this etch process has to remove this porous layer in a selective way especially with respect to the thin film and the semiconductor devices therein but preferably also with respect to the substrate. The method of the present invention surprisingly succeeds to meet all the aforementioned requirements amongst others because the support is used as an etch mask to protect the semiconductor devices during the nonmechanical removal step.

By using a high quality Si-containing substrate high temperature processing steps such as the chemical vapor deposition of Si, the diffusion and thermal oxidation of the thin film surface can be performed as for usual processing on thick crystalline Si substrates without fearing degradation in the minority carrier life time or contamination caused by the substrate. Also other high quality semiconductor substrates such as Ge or GaAs substrates can be used.

At least one semiconductor layer, defining a thin film, is deposited onto the porous surface layers by adequate deposition techniques. Particularly, crystalline Si layers of acceptable quality can be formed using a chemical vapor deposition technique. During deposition these layers can already be doped in order to create one or more p-n junctions in the thin film by switching between different gas atmospheres using different doping gasses. Additionally impurities can be diffused at the exposed thin film surface to form further junctions or highly doped contact regions. This can be done in a selective way as described in applicant's PCT patent application WO 98/28798 which is hereby incorporated by reference.

Solar cells can be formed in the thin film semiconductor layers comprising at least one n-type doped region and at least one p-type doped region in these semiconductor layers. Particularly both n-type and p-type doped regions can be contacted at the same surface. The exposed surface will be passivated typically by using thermal oxidation and/or SiNₓH_{y} deposition steps. The SiNₓH_{y} deposition can at the same time lead to a bulk passivation in the thin film if it is followed subsequently by a high temperature step. As for example, the short high temperature firing step for forming printed metal connections contacting the n-type and p-type regions. The metallisation is preferably performed by simple industrially applicable techniques such as screen printing of metal pastes. Contact to the n-type doped region is typically made by printing a pattern of Ag paste. Contact to p-type doped regions is typically made by printing a pattern of an Al, an Ag or an AgAl paste. The pastes are dried after printing and subsequently co-fired at elevated firing temperatures. During this short firing step not only good electrical contacts are formed to the differently doped regions, but also hydrogen will effuse from the SiNₓH_{y} layer into the thin film bulk region to passivate possible defects (as for instance at grain boundaries when poly-crystalline Si was deposited). After metallisation, the solar cell is functionally completed.
In case the final solar cell device will be used as back contact solar cell and therefore only the non-metallised surface will be illuminated as front surface of the device, a back surface reflector (BSR) might result in better light trapping properties and therefore better solar cell conversion efficiencies. This BSR might be applied optionally by first printing an electrically isolating paste (polymeric paste for instance) over one of the electrode metallisation patterns to thereby short circuiting the device when a metal is applied as BSR. Particularly, a highly reflective metal film can be applied over the whole back surface using techniques like evaporation or electroless plating. In case a non-conductive material of good reflectivity is used as BSR, this electrically isolating paste can be omitted. A BSR has however not necessarily to be formed directly in contact with the thin film solar cell. The use of a reflective layer as back sheet of a finished solar cell module might result in similar or better light trapping properties (depending on the used passivation layers on the rear surface) without asking for additional processing steps or cost.

At this stage of the process the substrate fulfills all tasks to have a simple and reliable processing sequence. Before lifting off the thin film however another substrate has to be attached to it as a support. This is preferably a cheap and flexible plastic or polymeric film, that can be applied by screen printing technology as well. A polymeric paste can be printed and subsequently dried at temperatures around 200 degrees C. Optionally this plastic film can be transparent. The support can be also attached by using an adhesive film in between the support and the thin film.

Finally the thin film solar cell with the support attached to it is detached from the substrate. The detached substrate is then subjected to a recycling step and is used for many further processing cycles. The detachment can be realized by under-etching the thin film solar cell with chemical etching solutions that remove selectively the porous semiconductor or oxidized porous semiconductor layers and using the support as an etch mask..

After detaching the thin film solar cell from the substrate the exposed surface of the thin film can be processed additionally. This might be for instance a SiNₓ deposition at moderate temperatures, i.e. compatible with the support e.g. 200 degree C for a plastic or polymeric support. The SiNₓ layer might serve as a passivation layer for this surface but also at the same time as an anti-reflective coating layer when the solar cell is used as a back contact solar cell. If the non-metallised surface however is used as back surface, an additional BSR layer might be applied optionally on this surface to achieve better light trapping.
Module interconnection of thin film semiconductor devices that are produced in the described way is simpler than for conventional thick Si substrates since both terminals are located on the same substrate surface and no connections have to be formed from front to rear surfaces. The interconnection can be done as for usual solar cell modules by using solder coated Cu strips that might be soldered to the busbars of n-type and p-type electrodes. This can be done already prior to the attachment of the plastic or polymeric support and the subsequent detachment of the thin film solar cells. It is however also possible to form openings at terminals in the support after finishing the process completely. Also monolithic module interconnection seems feasible.
All processing steps that have to be applied in this thin film solar cell process are simple and at low processing cost and can lead to high throughput. The final cost for the solar cell will mainly depend on the thin film deposition technique that is used. Calculations show that the cost per Watt of solar energy can be drastically reduced by applying such a process to less than 30% of the cost of today's industrially produced solar cells. This will mean a major break through of solar cell technology.

### BRIEF DESCRIPTION OF THE DRAWINGS

All drawings are primarily for better illustration of the main features and are not to scale. The devices and fabrication steps are depicted in a simplified way for the sake of better visibility. Not all alternatives and options are depicted in the figures and therefore the invention is in no way limited to the fabrication steps or device structures presented in those figures. For simplicity the figures are also limited to only half of the substrate. The method of the present invention is suited to form symmetrically on both major surfaces of the substrate exactly the same structures.

Figure 1 depicts, according to an embodiment of the invention, a schematic process flow for fabricating a simple thin film Si solar. A set of processing steps is depicted in figure 1 a) to figure 1 o).

Figure 2 depicts, according to the second embodiment of the invention, a schematic representation of a thin film Si solar cell with a grown floating layer (21) on the substrate before detachment from the substrate.

Figure 3 depicts, according to the third embodiment of the invention, a schematic representation of a thin film Si multi-layer solar cell with two layers of opposite doping type. Both demonstrated devices are still attached to the substrate prior to the detachment step.

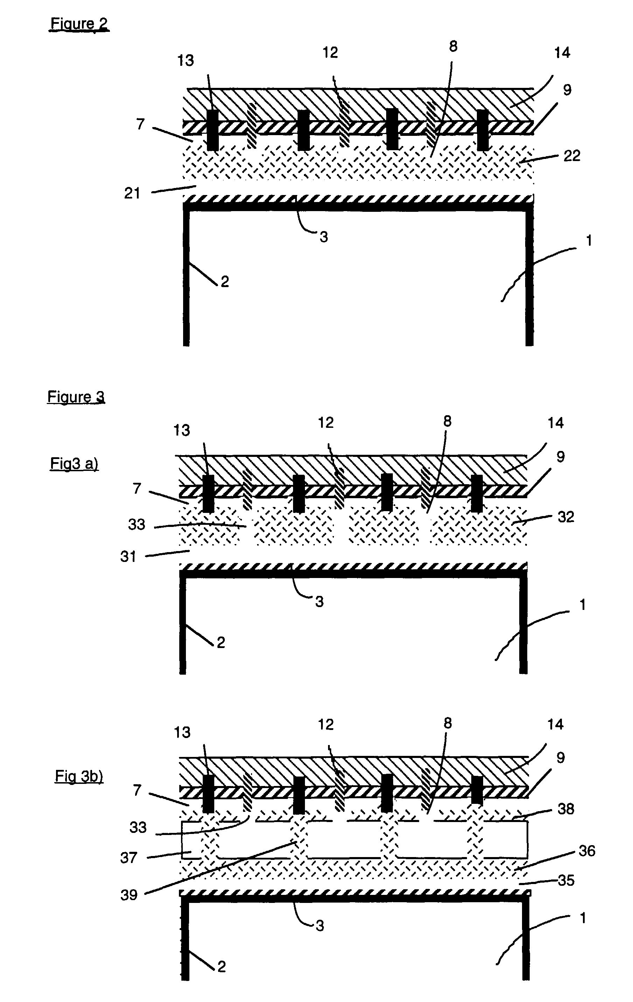

Figure 3 a) depicts, according to this third embodiment of the invention, a thin film Si multi-layer solar cell with a n-type layer (31) and a p-type layer thereon(32). This n-type layer (31) is selectively connected by means of a highly doped n-type region (33).
Figure3 b) depicts, according to this third embodiment of the invention, a thin film Si multi-layer solar cell with a p-type layer (36), a n-type layer (37) and again a p-type layer (38) thereon. This n-type layer (37) is selectively connected by means of a highly doped n-type region (33) and the p-type layer (36) is selectively connected by means of a highly doped p-type region (39).

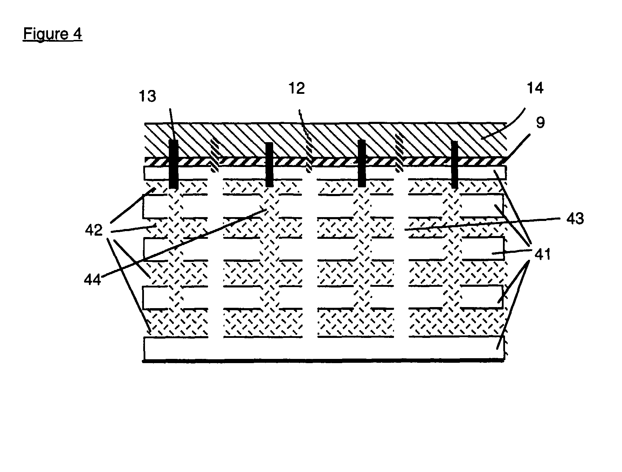

Figure 4 depicts, according to the fourth embodiment of the invention, a schematic representation of a thin film Si multi-layer solar cell with a plurality of layers of alternating and opposite doping type. All p-type layers (42) are connected by means of a highly doped p-type connection region (44), all n-type layers (41) are connected by means of a highly doped n-type connection region (43). The depicted structure is detached from the substrate.

### DETAILED DESCRIPTION OF THE INVENTION

In relation to the appended drawings the present invention is described in detail in the sequel. It is apparent however that a person skilled in the art can imagine several other equivalent embodiments or other ways of executing the present invention, the spirit and scope of the present invention being limited only by the terms of the appended claims. Therefore, although the method of the present invention to form thin film semiconductor devices with a simple and cheap process is not limited to Si solar cells the following description of some embodiments will be limited for simplicity and clarity to Si solar cells.

It should be noted that high temperature steps can enhance the quality of Si thin film, provided that defects in the thin film diffuse at considerably high rates during such high temperature treatments. In that case the defects can diffuse to the porous Si layer or to the high quality low defect density Si substrate having and get trapped.

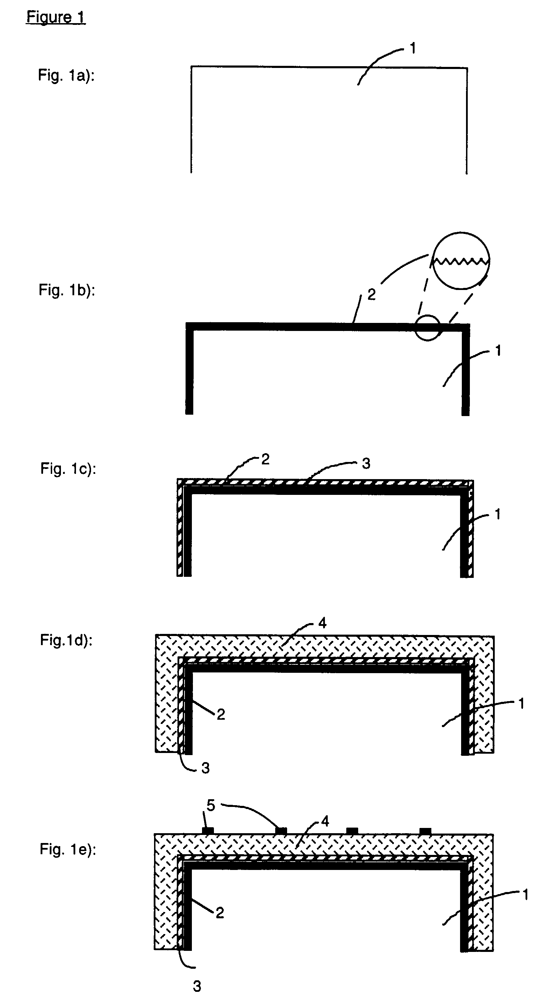

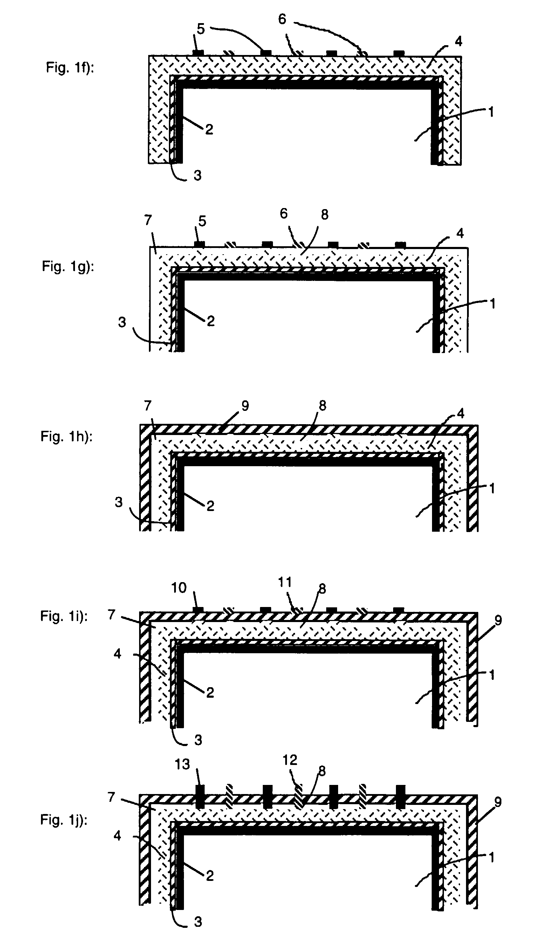

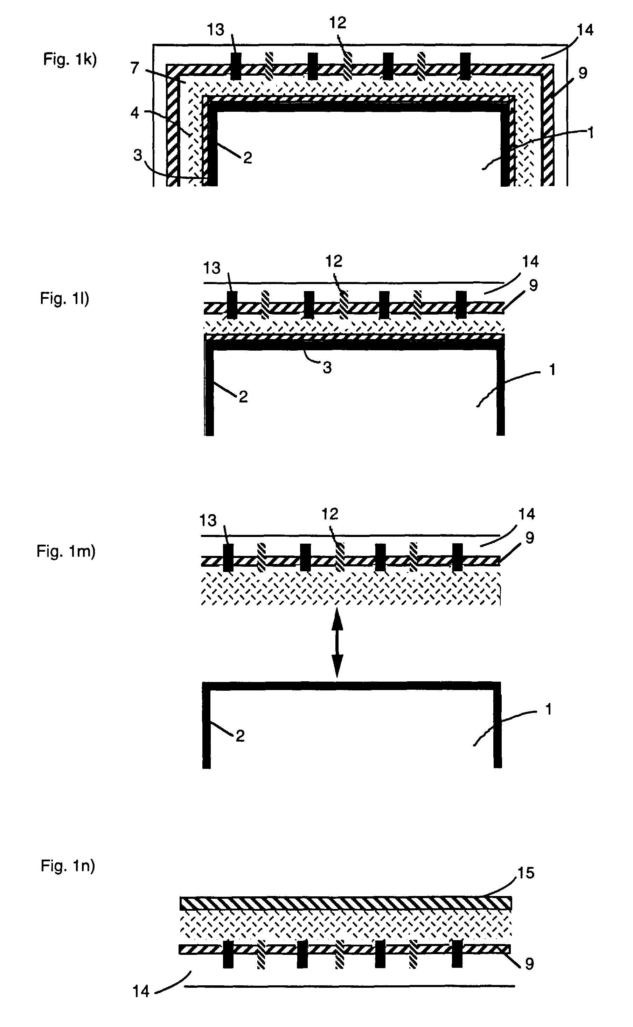

In a preferred embodiment of the invention, as in figure 1, a method is disclosed for fabricating thin film solar cells on a reusable Si substrate. Preferably a mono-crystalline Si substrate (1) (Fig. 1 a)) of good quality with respect to the purity of the Si (high minority carrier life time) is chosen to serve as a substrate during thin film deposition and subsequent processing before the finished solar cells are detached from this substrate and the substrate is prepared in a recycling cycle to serve for many other thin film production cycles. Alternatively, also multi-crystalline Si substrates or other crystalline Si substrates of reasonably good Si quality can be used. The thick, typically 300 µm or more, substrate has to be cleaned at the start of the process from surface contamination by means that are well known to persons skilled in the art of solar cell processing.

Subsequently (Fig. 1b)) the substrate surfaces can undergo an optional texturing or structuring step, creating a macroscopic structure (2) that will be found back as a negative structure on the deposited thin film after detaching the thin film solar cell at the end of the processing sequence. Even though this texturing or structuring of the surface is not required for the device formation, it will serve in the finished solar cell device as light trapping scheme, clearly improving the final solar cell conversion efficiency. The texturing or structuring of the device can be performed by methods well known in solar cell processing as random alkaline texturing, mechanical structuring or even more elaborated light trapping schemes as described in the literature. Since the mentioned macroscopic structure will be substantially the same after recycling the substrate at the end of the processing it can be used over several thin film solar cell manufacturing cycles and has not to be renewed after each process cycle.

In a next step, fig. 1c), a thin porous Si layer (3) is formed by an electroless etching technique in an aqueous chemical solution. This chemical solution typically comprises water (H₂O), hydrofluoric acid (HF), and nitric acid (HNO₃). Additives, such as PVA (polyvinyl alcohol) or PVP (polyvinyl pyridine) or other additives known to persons skilled in the art, that might improve the homogeneity of the porous Si film. An electroless etching step for porous silicon formation can be performed on many substrates simultaneously. For instance, a plurality of substrates can be immersed in a tank with the aqueous chemical solution. This yields a high throughput, good controllability and homogeneity. On the other hand, a galvanic porous silicon formation technique requires to contact the substrates to an electrode which incompatible with the requirement for a high throughput and therefore makes this technique less suitable for industrial application. The porous Si layer is used as a sacrificial layer and will be removed at the end of the process. During processing it might serve for gettering impurities and defects from the deposited thin film. These impurities and defects might diffuse into the much larger bulk Si substrate having a very low concentration of impurities and defects or they might be trapped on the huge surface area of the porous layer. The latter holds especially if the porous Si layer and/or the underlying substrate are highly doped by phosphorous which is well known by persons skilled in the art of solar cell processing to trap impurities and defects during gettering.

The surface concentration of either n-type impurities or p-type impurities in the porous Si film might optionally be intentionally increased. This step can be executed after or prior to the porous Si formation. The first option has the advantage that extremely high doping impurity concentrations can be achieved by the huge surface area that interacts with the diffusion source. The latter option has the advantage that the surface layer of the substrate has a different doping than the bulk of this substrate. This allows during porous Si formation for structures of completely different porosity in the diffused top region and the bulk region just below. Such a double structure in the porous film might facilitate the detachment of the thin film Si solar cell at the end of the process.

The porous Si formation step can be optionally followed by a thermal oxidation step or an oxide deposition step. During thermal oxidation the porous Si layer is transformed in an SiO₂ film that might be still porous or amorphous in its structure. Such a film can be under-etched selectively at the end of the process using a wet chemical etch based on e.g. concentrated HF solutions. Growing a Si thin film on a SiO₂ layer will however result in a poly-crystalline structure of this film, while the growth on porous Si directly allows to reproduce the mono-crystallinity of the substrate.

The formation of a porous surface layer for lift-off purposes is followed by a thin film formation step, fig 1d). A Si layer (4) ranging from about one to several micrometer thickness is grown by an adequate deposition technique as for instance CVD growth of Si from gaseous sources. Temperatures for this technique are typically above 700 degrees C. The deposition technique and thickness of the final thin film can be chosen according to the final thin film structure. The light trapping properties as well as the achievable effective minority carrier life time at the end of the process determine the ideal thickness of the deposited layer. In case there is opted for oxidizing the porous silicon layer, then a thermal oxidation step can be executed during the temperature ramp-up in the Si growth system by using a oxygen containing gas atmosphere. The use of oxygen or inert gases as N₂ that always contain traces of oxygen being sufficient to oxidize a surface at elevated temperatures, will result in a poly-crystalline Si thin film after Si deposition. This gives however the advantage of saving processing cost because for the growth of mono-crystalline thin Si films a reducing gas atmosphere of highly pure H₂ is required during the temperature ramp up. Therefore the omission of highly pure H₂ will clearly reduce the cost of processing gasses.

Furthermore, during the thin film growth doping gasses can be controllably introduced and varied to thereby result in grown doping profiles or in junctions when different doping impurities of opposite type are introduced. To achieve steep transitions from one doping type to the other and to avoid cross doping as much as possible, the growth of Si of different types might be executed as well in locally separated processing environments (in a basically continuous deposition system with several deposition areas).Using these possibilities, junctions can virtually be located at any desirable plane in the bulk of the thin film device, that is parallel to the surface plane. This gives a lot of freedom in the choice of the final device structure of which a few are described here as exemplary embodiments. These embodiments are only examples of advantageous use of the invention. The invention is however not limited to these exemplary embodiments, but might be used in many other variations and modifications that are obvious to persons skilled in the art.

Further according to this first embodiment, as a first example, a p-type Si layer preferably with a high resistivity is formed using for instance boron, gallium or aluminum as doping impurity. No junction will be formed during the growth of the Si layer. Optionally a gradient or profile might be applied to have the doping concentration varying with depth in the layer. After the thin film formation on all surfaces of the substrate, a masking paste (5), preferably a dielectric paste or a paste with the same type of doping impurities as the thin film layer is printed (fig. 1e)) to those areas of the surfaces that require a metal connection to contact the p-type regions to thereby form p-type electrodes. This masking pattern might be slightly wider than the final metallisation pattern to avoid possible shunt paths between the two types of electrodes to be formed. The masking paste is dried and avoids any n-type in-diffusion at those areas. An n-type doped diffusion paste (6) is printed and subsequently dried (fig 1f)) in a manner to obtain an inter-digitated electrode structure. This pattern is similar to the final metal pattern defining the n-type electrode and is typically also chosen to be slightly wider (margin for alignment) than the final n-type electrode. During the diffusion at elevated temperatures the regions at which the diffusion paste was printed will become heavily n-type doped by diffusing for instance P from the source material into the underlying semiconductor layer thereby forming a highly doped n-type region (8). At the same time, however, P diffuses indirectly via the gas phase from the source material into those areas that are not covered by diffusion or masking pastes thereby forming a weakly doped n-type region (7) at all these areas. Alternatively, a p-type dope paste instead of a dielectric paste can be used as a masking. This can be for instance a boron paste, an Al paste or Ga paste. These pastes are able to form during diffusion p, p⁺ or p⁺⁺ regions and might be additionally covered by a slightly wider pattern of masking paste, as for instance a SiO₂ paste, to avoid cross diffusion effects and/or low lateral shunt resistance values between p- and n-type regions.

After removing the remaining traces of paste materials the substrate surface can be passivated by a passivation step or sequence. This might include the growth of a thermal oxide layer that can passivate the surface effectively. Preferably a SiNₓH_{y} layer (9) is deposited (fig. 1h) by techniques like plasma enhanced chemical vapor deposition (PECVD). This layer serves when used together with a short high temperature annealing step as a passivation layer for surface and bulk of the thin Si film. An example of such a temperature annealing step is e.g. the metallisation firing of screen printed contacts which is applied later in the processing. The passivation arises from atomic hydrogen being released from this SiNₓH_{y} layer during the temperature annealing step and effusing from this SiNₓH_{y} layer into the underlying semiconductor layer. The SiNₓH_{y} layer can be optionally deposited in addition to a thermal oxide or as the only passivation layer. Additionally it can serve as anti-reflective coating layer if this surface of the thin film device is later used as front surface of the solar cell. The passivation of the surface regions is an important requirement for the thin film devices since the relative importance of the surface region increases with decreasing device thickness. Other passivation layers well known to persons skilled in the art can also be applied alternatively or additionally to the mentioned ones.

After surface passivation both electrodes of the device have to be metallised to end up with a operational thin film solar cell. This is preferably done by using a 'firing through technique' that allows to make contact through the passivation or anti-reflective coating layers using screen printing of advanced metallisation pastes at optimised firing conditions (fig.1 i)). Typically a Ag paste is printed in alignment with the highly doped n-type regions (11) and an Ag, AgAl or Al paste (10) in alignment with the p-type regions. The pastes are individually dried and then preferably co-fired at the same time. During the firing step low resistive electrical contacts (12) and (13) are formed to the respective solar cell electrode regions as can be seen from figure 1 j) without causing shunt resistance by metal particles that might penetrate through the junction of the n-type contact region if no care is taken or when the junction depth of this n-type contact region is too shallow. Typically inter-digitating patterns of elongated contacts are used for both metallisation patterns leading to a terminal busbar region on opposite sides of the solar cell. These terminal busbars facilitate the interconnection of the thin film solar cells in modules. The thin film Si solar cell is at this stage principally finished and operational. However the quite expensive substrate is still firmly attached to it and should be used again for many subsequent processing cycles in order to reduce the processing cost considerably.

Therefore a support is applied on the metallised surface of the thin film solar cell (see also fig. 1k). This support (14) should serve after lift-off of the thin film structure from the substrate (1) as new substrate or superstrate. The support (14) can serve at the same time as back surface reflector (BSR) if this side of the thin film solar cell is going to be used as rear surface and therefore will not be illuminated. Preferably the support should be easy to apply, cheap, flexible and it has to withstand the subsequent lift-off procedure or other subsequent processing steps. Particularly the support has to act as an etch mask or etch barrier during the nonmechanical detachment step. In other words the etch mask is a layer which at least avoids that a surface which is covered by this layer is exposed to the etch solution to thereby avoid damaging this surface during the etch process. Preferably also the etch mask itself is not or only limited affected by the etch solution. Ideally the support is a plastic or polymeric film that can be easily applied by screen printing a polymeric paste onto the surface and drying it. Also other cheap methods to attach such a support, or supports composed of a different material can be used. If the metallised surface is going to be used as front surface of the final thin film solar cell, then the support has to be a transparent superstrate film in order to allow light to enter the solar cell device.

The thin film solar cell is lifted off (fig.1 m)) from the substrate by selectively removing the porous interface layer (3) using the support as an etch mask. This step is preferably executed by under-etching using a chemical etching solution that selectively attacks the electroless porous Si or oxidised porous Si but does not attack substantially the Si semiconductor layer. By doing so, no surface damage is introduced at the thin film solar cell surface that was attached before to the substrate. However, the formation of the Si thin film can also result in a coverage of the edge regions of the substrate. In that case there is no direct access for chemical solutions to the porous Si layer or oxidised porous Si layer. Therefore, the Si thin film is removed (fig.1 l)) at the edge regions, preferably by grinding, etching or cutting, before the substrate can be detached. Alternatively this access can be achieved by applying the same techniques already at the beginning of the process directly after the thin film growth. This allows to diffuse also the edge regions when this seems favorable or beneficial for the final cell performance.

The interconnection strips for module assembling of the thin film solar cells can optionally be attached by soldering prior to the attachment of a support or by creating openings in the support to access the busbars of both electrode metallisation patterns.

After detachment of the completed solar cell structure the surface that was before in contact with the substrate is still basically unpassivated. Therefore an additional SiNₓ or TiOₓ deposition can be performed (fig.1 n)) on this surface. If plastic or other organic materials are used as a support the deposition temperature for these materials has to be adapted. Experiments show that temperatures down to 150 degrees C still allow for the deposition of uniform and homogeneous passivating layers (15) that might serve at the same time as anti-reflective coating (ARC) layer when this surface of the thin film solar cell is used as front surface. For simplicity the figures and the description are limited to only one half of the substrate. Obviously the process is suited to form symmetrically on both major surfaces of the carrier substrate exactly the same structures.

Which of the surfaces is to be used as the front surface depends strongly on the quality of the deposited thin film layer and the respective minority carrier life time after processing, on the final active device thickness, on the light trapping behaviour and on the shading losses related to the metallisation patterns in case the metallised surface is chosen to be the front surface. In the latter case the support has to be transparent. This transparent support might be for instance an ethyl-venylacetate (EVA) that is laminated to the surface. EVA is typically used anyhow for module encapsulation and might serve directly as encapsulant.

In a second embodiment of the present invention (figure 2), as a second example, the formation of the thin film is such that initially a very thin layer of n-type Si is grown (21). The thin film growth is then completed by a bulk layer of p-type Si material (22) and further processing is executed as described in the first preferred embodiment. One of the reasons to form such a thin n-type Si layer on the surface that is only accessible at the end of the process is to obtain a better passivation of this surface because weakly doped n-type Si layers can be much easier and better passivated. At the end of the process, this n-type Si layer either results in a completely isolated floating junction or can still be connected via a relatively high resistive path over the edge regions of the thin film if the access to the porous layer underneath is opened before the diffusion process or in other words if the thin film is removed at the edge regions previous to n-type diffusion.
The use of such a thin floating junction can result in considerably improved values of the open circuit voltage. This is of particular interest if this surface is the illuminated front surface and if the bulk thickness of the thin film is smaller than the minority carrier diffusion length. However also when the thin film solar cell is not used as back contact solar cell and the metallised surface is illuminated, the illumination level for really thin solar cells with good light trapping behaviour will be still considerably higher than for conventional thick crystalline Si solar cells and therefore benefits from a floating junction passivation can be more pronounced.

In a third embodiment of the present invention (figure 3), as a third example, the formation of the thin film is such that a Si multi-layer is formed comprising at least two Si layers of opposite doping type which define a p-n junction being located in the bulk of the thin film but sufficiently close to the exposed surface of the thin film surface in order to allow that this p-n junction can be reached by local diffusions from the exposed surface. Such structures are of particular interest when minority carrier diffusion lengths smaller than the device thickness are encountered at the end of the thin film solar cell fabrication process. One can either start with the formation of an n-type or a p-type doped layer on the porous silicon layer and continue with an opposite doped layer on top. Both options seem to be feasible.

As a first option, figure 3 a), according to this third embodiment of the invention the thin film deposition starts with the deposition of a n-type layer (31) on the substrate (1), that has a porous layer (3) on it's textured surfaces (2) as previously described. By switching to another doping ambient subsequently a p-type layer (32) is deposited. Finally a selective diffusion is used to form the n-type layer (7) that is weaker doped than the selectively heavily and deeply doped regions (33) that are formed during a selective diffusion step. The diffusion at these areas penetrates that deep in the substrate that the p-type layer (32) gets locally over-doped by n-type doping atoms. By doing so access is provided to the still deeper n-type layer (31). The deep n-type layer, the deeply n-type doped region (33) and the weakly doped n-type surface layer (7) are all electrically connected and contacted by means of a metal connection (12) (preferably by screen printing an Ag paste). The other processing steps can be executed according to the first embodiment of this invention. The resulting structure differs from the one described in figure 2 because now all three layers of the n-p-n stack are actively contributing to the collection of minority carriers. In that way the collection volume of the thin film solar cell can be increased particularly in case the minority carrier diffusion length is smaller than the device thickness.

Particularly the n-type layer (7) and the n-type doped regions (33) can be formed by selectively printing a diffusion paste while other areas can be masked from diffusion by a masking paste for instance. During the diffusion step, those areas that received diffusion paste will get heavily diffused resulting in n⁺⁺ region (33) that have to penetrate through the p-type Si layer. Penetration depths in the order of 1µm can be easily achieved when using a phosphorous paste and the grown junction can consequently be located 1µm below the surface giving still local access to the buried grown n-type Si bulk layer (31). All areas that were neither covered by the diffusion paste nor by the masking paste will get weakly and shallow doped n layers (7). This is again due to the indirect diffusion via the gas phase, mentioned earlier. This allows consequently to have all major surfaces n-type again which is advantageous to obtain an effective passivation. This results basically in a structure with a p-type layer sandwiched between two n-type layers, having all three layers connected to electrode terminals on the processing surface.

As a second option, figure 3 b), according to this third embodiment of the invention the thin film deposition starts with the deposition of a thin n-type floating emitter layer (35) on the substrate (1), that has a porous layer (3) on it's textured surfaces (2) as previously described. This is followed by deposition of a p-type layer (36), an n-type layer (37) and another p-type layer (38). During a subsequent diffusion step, two diffusion pastes of opposite type are used. The p-type regions (39) get very deeply diffused, while the n-type regions (33) get just deeply enough n-type diffused to access the n-type layer (37). The weakly doped regions (7) are created in the same manner as in the previous embodiments. The p-type regions (39) used to access the buried p-type layer (36) can be formed either during diffusion using a paste with a p-type doping impurity as Al, Ga or B or only at the end of the solar cell processing sequence using an A1 paste for metallisation. Al alloys very fast with Si already at temperatures above the eutectic temperature of about 580 degree C and can be used to penetrate locally deeply (high diffusion rate) inside the Si layers. This allows to locate the device junction at virtually any desired location of the thin film as for instance at half of its thickness having still the possibility to connect the buried p-type layer to the metal grid that will be formed on the surface that is accessible for processing before lifting off the thin film solar cell. The p⁺⁺ regions of Al alloys can penetrate easily 20 µm or more if required. These regions should be well separated from the n⁺⁺ regions (33). The grown n-type Si layer (37) should be of rather high resistivity to avoid shunt paths to the p⁺⁺ regions (39). The possibility to locate the grown junction plane at virtually any desired location parallel to the surfaces can give the same advantages as described in the discussion of fig.3 a). Furthermore, positioning the junction in the middle of the device might be an advantage due to the increase of the accessible collection volume of the device which can result in better conversion efficiencies of the thin film solar cell.

In case no optional n-type layer (35) is formed on the porous Si layer, then the p-type surface that is in contact with the substrate during processing might not be easy to passivate when using the same processing sequences to finish the solar cell as described in the previous embodiments. In case an additional thin n-type layer (35) is formed then this layer can be either completely floating or connected via a diffusion along the edge of the thin film as already described in embodiment 2. All other processing steps as diffusion, passivation and metallisation can be executed basically in the same way as described in the previous embodiments.

In a fourth embodiment of the present invention (figure 4), as a fourth example, the formation of a multi Si layer thin film is such that a thin film Si solar cell is formed comprising a plurality of parallel collecting junctions in the bulk of the device. Particularly, when the used deposition techniques for thin film formation result only in Si layers of modest quality and lower minority carrier diffusion lengths than the device thickness, it is advantageous to have as many as possible parallel collecting junctions in the bulk of the device in order to increase the responding collection volume clearly. Figure 4 depicts such a multi Si layer thin film device with a plurality of n-type layers (41) and p-type layers (42) that are all formed by Si deposition in alternating doping source ambients. Such an alternated deposition could occur at different locations in a quasi-continuous deposition system without having to ramp the temperature up and down between the consequent individual deposition steps. To connect all individual layers to the surface that is metallised by the contacts (12) and (13) as for previously described cells, a deep local diffusion of both doping impurity types is required to form the highly doped connection regions (43) and (44). The fabrication of such connection regions without shunting the solar cells is quite difficult. This can be done by applying selectively the diffusion sources of the respective type as for instance by screen printing doping pastes and using masking paste to avoid lateral cross diffusion. Care has to be taken that during the diffusion no excessive cross doping will occur between the grown Si layers of different doping type since the thickness of each of this layers is substantially smaller than the device thickness through which the local diffusions extend. Therefore the use of different doping impurity atoms during the thin film growth process and for the local diffusions seems to be unavoidable. Doping impurities like Al and P, that diffuse at reasonably low temperatures comparably fast through Si, have to be used in diffusion pastes for the selective formation of the connection regions. Doping impurities like B and Sb that diffuse at typical diffusion temperatures only slowly are preferably used for doping the various Si layers during the Si thin film growth. The various n- and p-type Si layers should be preferably weakly doped to avoid lateral shunt paths in the Si bulk between the different strongly doped connection regions that will be metallised.

It should be stressed once more that the present invention is by far not limited to Si solar cell devices as discussed in the previous embodiments. Other semiconductor materials can be used as well. Combinations of different semiconductor layers seem attractive as well. For instance a stack of Si and SiGe layers could offer an interesting tandem solar cell device. Si layers could serve for better surface passivation, while sandwiched thin SiGe layers very closely spaced from the front surface could offer a better choice in converting highly energetic photons. The layers can be grown in the same way as the previously described junctions can be grown, i.e. by switching the gas atmospheres during deposition. Furthermore, also other semiconductor devices such as diodes or power devices can be fabricated according to the method of the present invention to drastically reduce the overall cost by using a comparably cheap Si thin film on a cheap substrate without increasing processing cost considerably.

## Claims

1. A method for fabricating thin film semiconductor devices on a reusable substrate of a semiconductor material comprising the steps of:
providing a substrate of a semiconductor material having at least one surface;
forming at least one porous layer on said surface of said substrate;
depositing at least one semiconductor layer on said porous layer;
forming active devices in said semiconductor layer;
forming electrical contacts to said active devices;
attaching a support to the surface overlying said metal connections; and
non-mechanically detaching said substrate from said semiconductor layer by removing said porous layer with a wet chemical etch using said support as an etch mask.

2. A method as recited in claim 1, wherein said porous layer on said surface of said substrate is formed by an electroless etching technique in an aqueous chemical solution.

3. A method as recited in claim 1, wherein said surface of said substrate is textured or structured prior to forming said porous semiconductor layer.

4. A method as recited in claim 1, wherein said support is composed of a plastic or a polymer.

5. A method as recited in claim 1, wherein said porous layer is a single porous semiconductor layer.

6. A method as recited in claim 5, wherein said single porous semiconductor layer is formed such that there is a gradient in porosity.

7. A method as recited in claim 5 or 6, wherein said porous semiconductor layer is a porous silicon layer, said method further comprising the step of thermally oxidizing said porous silicon layer to thereby convert said porous silicon layer to a porous silicon oxide layer.

8. A method as recited in claim 7, wherein said substrate is detached from said semiconductor layer by removing said porous silicon oxide layer using a wet chemical etch, said wet chemical etch being selective to said substrate and said semiconductor layer.

9. A method as recited in any of claims 1 to 8 wherein said active devices comprise at least one n-type doped region and at least one p-type doped region being formed in said semiconductor layer and having an exposed surface, and wherein said n-type region and said p-type region of said active devices are contacted at said exposed surface by said metal connections.

10. A method as recited in claim 9, wherein said metal connections are formed by screen printing a first metal paste to contact said p-type doped regions and a second metal paste to contact said n-type doped regions.

11. A method as recited in claim 1, wherein said semiconductor material of said substrate is selected from the group consisting of Si, SiGe, Ge, GaAs.

12. A method as recited in claim 11, wherein said substrate is doped with either an n-type impurity or a p-type impurity, said substrate having a highly doped surface region whereon said porous layer will be formed.

13. A method as recited in claim 1, wherein each of said semiconductor layers is either an n-type or a p-type doped layer being composed of a semiconductor material selected from the group consisting of Si, Ge, SiGe, GaAs.

14. A method as recited in claim 13, wherein said thin film semiconductor devices are thin film solar cells having a plurality of actively collecting semiconductor layers of different doping types.

15. A method as recited in claim 1, wherein after detaching said substrate an additional layer is formed on exposed parts of said semiconductor layer, said additional layer being used at least as a passivation layer or an anti-reflective coating layer or a back surface reflector layer.

16. A method for fabricating thin film semiconductor devices on a reusable substrate of a semiconductor material comprising the steps of
providing a substrate of a semiconductor material having a first major surface, a second major surface, opposite to said first major surface, and edge surfaces;
forming at least one porous semiconductor layer on each of said major surfaces and said edge surfaces of said substrate by an electroless etching technique in an aqueous chemical solution;
depositing at least one semiconductor layer on said porous semiconductor layer;
forming active devices at least in the semiconductor layers formed on said first major surface of the substrate;
forming metal contacts at said first surface of said substrate contacting said active devices;
attaching a support to the surface overlying said metal connections;
removing at least the semiconductor layers formed at the edge surfaces of the substrate to thereby expose the edges of the porous semiconductor layers; and
non-mechanically detaching said substrate from said semiconductor layer by removing said porous layer with a wet chemical etch using said support as an etch mask.

17. A method as recited in claim 16, wherein thin film semiconductor devices are fabricated both in the semiconductor layers formed on said first major surface of the substrate and on said second major surface of the substrate.
